# EUROPEAN PATENT APPLICATION

(11) **EP 4 386 050 A1**
(43) Date of publication of application: **19.06.2024**
(21) Application number: 22869104.4
(22) Date of filing: 08.09.2022
(51) Int. Cl.: C08L 67/02, C08L 67/00, C08K 3/22, C08K 3/34, C08K 7/14

(54) **POLYESTER RESIN COMPOSITION AND PREPARATION METHOD THEREFOR AND APPLICATION THEREOF**

(30) Priority: 18.09.2021 CN 202111113045
(71) Applicant: Zhuhai Vanteque Specialty Engineering Plastics Co., Ltd., Zhuhai City, Guangdong 519050 (CN); KINGFA SCI. & TECH. CO., LTD., Guangzhou, Guangdong 510663 (CN)
(72) Inventor: YAN, Kun, Guangzhou, Guangdong 510663 (CN); XU, Xianjun, Guangzhou, Guangdong 510663 (CN); JIANG, Sujun, Guangzhou, Guangdong 510663 (CN); CAO, Min, Guangzhou, Guangdong 510663 (CN); MAI, Jiehong, Guangzhou, Guangdong 510663 (CN); YANG, Huixin, Guangzhou, Guangdong 510663 (CN); JIANG, Zhiqiang, Guangzhou, Guangdong 510663 (CN)
(74) Representative: dompatent von Kreisler Selting Werner - Partnerschaft von Patent- und Rechtsanwälten mbB
(86) International application number: PCT/CN2022/117708
(87) International publication number: WO 2023/040735

(57) **Abstract**

The present invention relates to a polyester resin composition, a preparation method thereof and use thereof. The polyester resin composition includes a PCT resin, a white pigment, a reinforcing material, a polyester elastomer, and other additives. The polyester resin composition provided by the present invention has a strong binding force with a silica gel; when the polyester resin composition is made into an LED reflecting support, the LED reflecting support is not easy to separate from the silica gel in high temperature and high humidity environments, such that the service life of an LED lamp bead can be effectively prolonged; and meanwhile, the polyester resin composition has good toughness, and would not cause the problem of powder falling under repeated stress.

## Description

### TECHNICAL FIELD

The present invention belongs to the technical field of thermoplastic resin, and specifically relates to a polyester resin composition, a preparation method thereof and use thereof.

### BACKGROUND

The birth of light emitting diode (LED) enables the illuminating industry to enter into an era of semiconductor lighting. The LED light source has the advantages of high reliability, high light emitting power, low power dissipation, fast corresponding speed, long service life, low price, and is rich in color. LED has become a new generation of mainstream lighting technology following coal gas lighting, incandescent lamp, and fluorescent lamp. With the development of the times and the progress of science and technology, LED has been widely applied in various fields such as street lamps, indoor lighting, backlight display, automotive headlamps, and landscape lamps.

LED support, as a chip carrier, not only plays the role of electric conduction, but also exerts the effect of heat conduction and thus, is an indispensable key accessory to LED device. Materials used as a LED support mainly include high temperature-resistant polyamide (PPA) and high temperature-resistant polyester (poly(1,4-cyclohexylenedimethylene terephthalate), PCT). The high temperature-resistant polyamide (mainly including PA46, PA6T, and PA9T) has a higher initial whiteness, good heat resistance, and high mobility. It is suitable for injection molding process and has lower costs and thus, is the mainstream material for LED support. However, the PPA material has a fast light-heat aging/attenuation rate and thus, can be only used to low-power products at present. With the emergence of high-voltage LED, PCT has greater advantages in the application of a medium/high-power LED reflecting support due to its excellent high-temperature color-fading resistance.

LED packaging process contains steps such as reflecting support pre-baking, die bonding, wire welding, dispensing, separation, light splitting, and braiding, of which, the separation refers to the process that a whole piece of metal strip containing LED lamp beads which have been bonded, wired and dispensed is extruded by a full-automatic thresher such that each LED lamp bead separates from the metal strip. The groove portion of the LED reflecting support and the protruding portion of the metal strip are inlaid together, and extruded in the full-automatic thresher repeatedly, and then separated. During such process, the metal strip interacts with the LED reflecting support. However, the LED reflecting support made of PCT materials has poor toughness, and is easy to break after repeated stress, causing the problem of powder falling, thereby leading to the scrap of the LED reflecting support and other problems, seriously affecting the subsequent packaging process.

LED packaging adhesive mainly includes epoxy resin and silica gel. Silica gel has remarkable features such as superior mechanical property, ageing resistance, good thermal stability, weather resistance, flexibility, high transparency, small internal stress, and low hygroscopicity. Compared with epoxy resin, silica gel's properties can satisfy the packaging requirements of high-power and high-intensity LED products better. Therefore, silica gel is rapidly replacing epoxy resin to be a new generation of more ideal LED packaging material. However, the LED reflecting support made of PCT materials has poor binding force with silica gel. In practical use, there is a problem, i.e., the LED reflecting support is separated from silica gel. Oxygen and moisture in the air will invade into the LED lamp beads through the gap generated by the separation, causing the lamp beads damage or failure and decreasing its service life.

Patent CN102471565A discloses a flame retardant polymer composition. The addition of a specific polyester elastomer solves the problem of the reduced mechanical properties (elongation at break and resistance against wear) during the introduction of a flame retardant; the obtained composition not only has good fire retardancy and good mechanical properties (elongation at break and resistance against wear), and after heat aging, the mechanical properties stay on a very high level. However, the composition is mainly applied to prepare ultra-thin cable; moreover, the invention does not concern the binding force of the polyester resin composition with silica gel, as well as the problem of powder falling during the separation process of the LED packaging when the composition is made into an LED emitting board and the service life of the LED lamp beads.

Therefore, it is of great research significance and application value to develop a novel polyester composition material which has strong binding force with silica gel and strong toughness, free of separation between the LED reflecting support and silica gel during the separation of LED packaging and free of damage under repeated stress, and can prolong the service life of LED lamp beads and avoid the problem of powder falling.

### SUMMARY

The objective of the present invention is to overcome the shortcomings or disadvantages such as, poor binding force between the polyester resin composition and silica gel, easy separation of the LED reflecting support from silica gel during the separation of LED packaging, short service life of LED lamp beads, and failure in effectively inhibiting powder falling during the separation of LED packaging. A polyester resin composition is thus provided herein. The polyester resin composition provided by the present invention has a strong binding force with a silica gel; when the polyester resin composition is made into an LED reflecting support, the LED reflecting support is not easy to separate from the silica gel in high temperature and high humidity environments, such that the service life of an LED lamp bead can be effectively prolonged; and meanwhile, the polyester resin composition has good toughness, and would not cause the problem of powder falling under repeated stress.

Another objective of the present invention is to provide a preparation method of the aforesaid polyester resin composition.

Another objective of the present invention is to provide use of the aforesaid polyester resin composition in preparing an LED product.

To achieve the above objectives, the present invention adopts the following technical solution:
A polyester resin composition, including the following components in parts by weight:
40-80 parts of PCT resin;
10-40 parts of a white pigment;
0-30 parts of a reinforcing material;
0.5-5 parts of a polyester elastomer; and
0-10 parts of other additives;
where the polyester elastomer includes a polyester hard segment and a polyether soft segment, has a Shore hardness of 40-74, and a melting point of 191-221°C.

With PCT resin as a matrix, the polyester resin composition of the present invention is added with a white pigment to adjust color; meanwhile, a specific polyester elastomer is added to promote its binding force and toughness with silica gel. Such a configuration of the present invention avoids the separation of the LED reflecting support from the silica gel during the separation of LED packaging, prolongs the service life of LED lamp beads, and at the same time, avoids the problem of powder falling under repeated stress. The detailed action principle may be as follows:
The polyester elastomer consists of a polyester hard segment and a polyether soft segment. On the one hand, the polyester hard segment has good compatibility with the polyester matrix, and the polyether soft segment provides good toughness and bonding property. Through repeated studies, the inventor has found that the improvements to the polyester hard segment and the polyether soft segment achieve a balance by the control of specific hardness and melting point; the obtained polyester composition has a higher notch impact strength; the LED reflecting support made of the polyester composition is not prone to damage during seperation under the stress of metal strip, thereby avoiding the problem of powder falling.

On the other hand, the polyether soft segment of the polyester elastomer at a specific hardness and melting point contains a large number of hydroxyl groups and ether bond active groups, which can be subjected to chemical reaction with the hydrosilicon group on the surface of silica gel, thus improving the binding force of the polyester resin composition with silica gel. Moreover, it is free of the problem of separation between the LED reflecting support and silica gel in high temperature and high humidity environments, thereby prolonging the service life of the LED lamp beads.

In addition, toughness may be further enhanced by adding a proper amount of reinforcing material.

Preferably, the polyester resin composition includes the following components in parts by weight:
50-70 parts of the PCT resin;
20-35 parts of the white pigment;
5-20 parts of the reinforcing material;
1-4 parts of the polyester elastomer; and
2-8 parts of the other additives.

Preferably, the polyester elastomer is of a polyester-ether type, and has a Shore hardness of 46-63, and a melting point of 195-212°C.

The conventional PCT resin, white pigment, reinforcing material, and a proper amount of additives in the art may be used in the present invention.

The PCT resin has a structural formula of 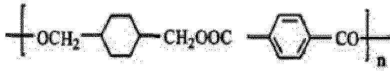 , and is obtained by the polycondensation between terephthalic acid and 1,4-cyclohexanedimethanol.

Preferably, the PCT resin has an intrinsic viscosity of 0.65-0.75 dL/g.

The intrinsic viscosity is determined as follows: weighing and dissolving 0.5 g sample into 100 mL of 60/40 (wt/wt) phenol/tetrachloroethane, and conducting an intrinsic viscosity test with a Ubbelohde viscometer at a constant condition of 25°C.

Preferably, the PCT resin has an intrinsic viscosity of 0.71-0.73 dL/g.

Preferably, the white pigment is one or more of titanium dioxide, zinc oxide, zinc sulfide, white lead, zinc sulfate, barium sulfate, calcium carbonate, and aluminium oxide.

More preferably, the white pigment is titanium dioxide.

Preferably, the reinforcing material is one or more of glass fiber, wollastonite, potassium titanate whisker, kaolin, talc, and mica.

Preferably, the other additives are one or more of an antioxidant (0-3 parts by weight available), an impact modifier (0-10 parts by weight available), a fire retardant (0-10 parts by weight available), a fluorescent brightener (0-5 parts by weight available), a lubricating agent (0-5 parts by weight available), a plasticizer (0-5 parts by weight available), a thickening agent (0-3 parts by weight available), an antistatic agent (0-3 parts by weight available), a nucleating agent (0-3 parts by weight available), a UV stabilizer (0-2 parts by weight available), a release agent (0-3 parts by weight available), a pigment (0-10 parts by weight available), and a dye (0-10 parts by weight available).

A preparation method of the aforesaid polyester resin composition includes the following steps: mixing the PCT resin, the white pigment, the reinforcing material, the polyester elastomer, and the other additives, conducting melt extrusion and granulation to obtain the polyester resin composition.

The use of the aforesaid polyester resin composition in preparing an LED product also falls within the protection scope of the present invention.

Preferably, the LED product is an LED reflecting support.

Compared with the prior art, the present invention has the following beneficial effects:
The polyester resin composition provided by the present invention has a strong binding force with a silica gel; when the polyester resin composition is made into an LED reflecting support, the LED reflecting support is not easy to separate from the silica gel in high temperature and high humidity environments, such that the service life of an LED lamp bead can be effectively prolonged; and meanwhile, the polyester resin composition has good toughness, and would not cause the problem of powder falling under repeated stress.

### DETAILED DESCRIPTION OF EMBODIMENTS

The present invention will be further described with reference to the examples. These examples are merely used to specify the present invention, but are not construed as limiting the scope of the present invention. In the following examples, the experimental methods not marked with specific conditions are usually subjected to the conventional conditions in the art or the conditions recommended by the manufacturer; unless otherwise specified, the raw materials, reagents, and the like used are all commercially available. Any non-substantive change and replacement made by those skilled in the art on the basis of the present invention falls within the protection scope set forth in the present invention.

A portion of reagents used in the examples and comparative examples of the present invention are described as follows:
PCT resin 1#: PCT 36296 from EastmanTM Chemical Products having an intrinsic viscosity of 0.719 dL/g (0.5 g samples were weighed and dissolved into 100 mL of 60/40 (wt/wt) phenol/tetrachloroethane, and the intrinsic viscosity test was conducted with a Ubbelohde viscometer at a constant condition of 25°C, the same below).
PCT resin 2#: 0302 from SK Chemicals having an intrinsic viscosity of 0.65 dL/g.
PCT resin 3#: 0502 from SK Chemicals having an intrinsic viscosity of 0.75 dL/g.
PCT resin 4#: PCT 36294 from EastmanTM Chemical Products having an intrinsic viscosity of 0.625 dL/g.

White pigment: titanium dioxide (TiO₂), R105 from DuPont Co., Ltd (US); zinc oxide (ZnO) UN3077 from LANXESS (China) Energizing Chemistry.

Reinforcing material: F7x28: CSG3PA-820 from NITTO BOSEKI, Japan having a fiber diameter of 28 µm; wollastonite, NYGLOS 8 from NYCO Minerals, Inc.

Polyester elastomer of polyester-ether type: from Royal DSM NV, with the model of Arnitel^{®} EM400 (Shore hardness of 40 and melting point of 191°C), EM460 (Shore hardness of 46 and melting point of 195°C), EM550 (Shore hardness of 55 and melting point of 207°C), EM630 (Shore hardness of 63 and melting point of 212°C), EM740 (Shore hardness of 74 and melting point of 221°C); from DuPont Co., Ltd, with the model of 8238 (Shore hardness of 82 and melting point of 221°C), and model 4056 (Shore hardness of 40 and melting point of 150°C); the Shore hardness was determined according to GB/T 2411-2008; and the melting point was determined according to ASTM D3418-2003.

Polyester elastomer of polyester-polyester type was from Royal DSM NV, Arnitel^{®} UM551 (Shore hardness of 55 and melting point of 200°C).

Silica gel: LED packaging silica gel UH-6950-1 (consisting of a gel A and a gel B) commercially purchased from Shenzhen Yongxinren Science and Technology Co., Ltd.

The preparation methods of the polyester resin composition and the test samples in the examples and comparative examples of the present invention are as follows:
The dried PCT resin and polyester elastomer were mixed well by a high-speed mixer, and added from the major feed port of a twin-screw extruder; white pigment, reinforcing filler, and other additives (if any) were added to the twin-screw extruder through a side feeding machine; the materials were melted, extruded, and granulated by the twin-screw extruder at a preset temperature of 230-300°C to obtain a granular polyester resin composition.

Test methods for the examples and comparative examples of the present invention are as follows:
Impact strength test: the test was conducted according to ISO 180-2013 for cantilever notched impact.

Powder falling test: the obtained polyester composition was injection molded into a square LED reflecting support (28 mm*35 mm, model: 2835); the number of the LED reflecting supports on a piece of metal strip was 36*22=792. The molded LED reflecting support was threshed with a full-automatic thresher, after all the LED reflecting supports were totally threshed, the number of the damaged LED reflecting supports was recorded, to simulate the powder falling condition after being encapsulated to a lamp bead. When the number of the damaged LED reflecting supports was below 100, it meets the operating requirement.

Tensile breaking force test: Sample preparation: a polyester resin composition was injection molded into a sample having a size of 80×20×2.0 mm. Test method: the gel A and gel B of silica gel were mixed well in a mass ratio of 1:4, 0.02 g were taken and dropped onto one end of the surface of a test sample, and the silica gel was pressed tightly with another test sample, and then fixed with a clamp. The samples were then put to a drying oven and pre-cured for 1 h at 80°C, and then heated up to 150°C and continuously cured for 4 h, and finished. The cured sample strips were subjected to an extension test at a tensile speed of 10 mm/min; the tensile breaking force was recorded. The present application characterizes the binding force of the molding product prepared by the polyester composition through the tensile breaking force. The stronger the tensile breaking force is, the stronger the binding force of the molding product prepared by the polyester composition with silica gel is; when the tensile breaking force is 350 N and above, it meets the practical usage requirement.

### Examples 1-18

The examples provide a series of polyester resin compositions; the parts of weight of each component in the formula are shown in Tables 1 and 2.

**Table 1 Formula (part) and performance test result of Examples 1-9**

| | Exam ple 1 | Exam ple 2 | Exam ple 3 | Exam ple 4 | Exam ple 5 | Exam ple 6 | Exam ple 7 | Exam ple 8 | Exam ple 9 |
|---|---|---|---|---|---|---|---|---|---|
| PCT resin 1# | 58 | 58 | 58 | 58 | 58 | 58 | 58 | 58 | 58 |
| White pigment (R105) | 25 | 25 | 25 | 25 | 25 | 25 | 25 | 25 | 25 |
| Reinforcin g material (F7x28) | 15 | 15 | 15 | 15 | 15 | 15 | 15 | 15 | 15 |
| Polyester elastomer | 2 | 2 | 2 | 2 | 2 | 0.5 | 5 | 1 | 4 |
| Polyester elastomer model | EM40 0 | EM46 0 | EM55 0 | EM63 0 | EM74 0 | EM55 0 | EM55 0 | EM55 0 | EM55 0 |
| Shore hardness | 40 | 46 | 55 | 63 | 74 | 55 | 55 | 55 | 55 |
| Melting point/°C | 191 | 195 | 207 | 212 | 221 | 207 | 207 | 207 | 207 |
| Notch impact strength/k J/m² | 5.9 | 6.4 | 6.5 | 6.2 | 5.9 | 5.4 | 5.5 | 5.6 | 5.7 |
| Number of damaged LED reflecting supports/p cs. | 29 | 16 | 8 | 19 | 30 | 41 | 38 | 35 | 33 |
| Tensile breaking force/N | 482 | 612 | 649 | 558 | 499 | 375 | 392 | 416 | 441 |

**Table 2 Formula (part) and performance test result of Examples 10-18**

| | Exam ple 10 | Exam ple 11 | Exam ple 12 | Exam ple 13 | Exam ple 14 | Exam ple 15 | Exam ple 16 | Exam ple 17 | Exam ple 18 |
|---|---|---|---|---|---|---|---|---|---|
| PCT resin 1# | 40 | 80 | 50 | 70 | / | / | / | 58 | 58 |
| PCT resin 2# | / | / | / | / | 58 | / | / | / | / |
| PCT resin 3# | / | / | / | / | / | 58 | / | / | / |
| PCT resin 4# | / | / | / | / | / | / | 58 | / | / |
| White pigment (R105) | 40 | 10 | 35 | 20 | 25 | 25 | 25 | / | 25 |
| White pigment UN3077 | / | / | / | / | / | / | / | 25 | / |
| Reinforcin g material (F7x28) | 0 | 30 | 5 | 20 | 15 | 15 | 15 | 15 | / |
| Reinforcin g material (NYGLOS 8) | / | / | / | / | / | / | / | / | 15 |
| Polyester elastomer | 2 | 2 | 2 | 2 | 2 | 2 | 2 | 2 | 2 |
| Polyester elastomer model | EM55 0 | EM55 0 | EM55 0 | EM55 0 | EM55 0 | EM55 0 | EM55 0 | EM55 0 | EM55 0 |
| Shore hardness | 55 | 55 | 55 | 55 | 55 | 55 | 55 | 55 | 55 |
| Melting point/°C | 207 | 207 | 207 | 207 | 207 | 207 | 207 | 207 | 207 |
| Notch impact strength/k J/m² | 5.3 | 6.0 | 5.4 | 6.2 | 5.7 | 5.9 | 5.4 | 6.1 | 6.2 |
| Number of damaged LED reflecting supports/p cs. | 72 | 24 | 45 | 19 | 34 | 28 | 43 | 22 | 18 |
| Tensile breaking force/N | 353 | 511 | 341 | 554 | 437 | 489 | 354 | 540 | 567 |

### Comparative Examples 1-4

The comparative examples provide a series of polyester resin compositions; the parts of weight of each component in the formula are shown in Table 3.

**Table 3 Formula (part) and performance test result of Comparative Examples 1-4**

| | Comparative Example 1 | Comparative Example 2 | Comparative Example 3 | Comparative Example 4 |
|---|---|---|---|---|
| PCT resin 1# | 58 | 58 | 58 | 58 |
| White pigment (R105) | 25 | 25 | 25 | 25 |
| Reinforcing material (F7x28) | 15 | 15 | 15 | 15 |
| Polyester elastomer | / | 2 | 2 | 2 |
| Polyester elastomer model | / | UM551 | 8238 | 4056 |
| Shore hardness | / | 55 | 82 | 40 |
| Melting point/°C | / | 220 | 221 | 150 |
| Notch impact strength/kJ/m² | 4.9 | 5.0 | 5.1 | 5.2 |
| Number of damaged LED reflecting supports/pcs. | 604 | 587 | 393 | 423 |
| Tensile breaking force/N | 141 | 167 | 281 | 304 |

The polyester resin compositions provided in each example and comparative example were subjected to performance tests according to the aforesaid performance test methods. Results are shown in Tables 1, 2, and 3.

As can be seen from the above test results, the polyester resin compositions provided in Examples 1-18 have good toughness and a higher notch impact strength; in the prepared LED reflecting supports, the number of the damaged LED reflecting supports during threshing is less than 100; moreover, the polyester resin compositions have a strong binding force with silica gel, and a tensile breaking force is greater than 324 N. In Examples 1-5, elastic polyurethanes with different Shore hardness were selected; with the increase of the hardness, the notch impact strength first increases and then decreases; the binding force of the polyester resin compositions with silica gel first increases and then decreases; when the Shore hardness is 46-63, the notch impact strength and the binding force with silica gel are further enhanced; when the tensile breaking force is above 558 N, the number of the damaged LED reflecting supports during threshing is less than 20. In Examples 3, and 6-7, with the increase of the amount of the elastic polyurethane used, the notch impact strength first increases and then decreases, and the binding force with silica gel first increases and then decreases; Example 3 achieves the optimal performance.

In Comparative Example 1, no elastic polyurethane was added for modification, the notch impact strength is lower, and the binding force of the polyester resin composition with silica gel is poor; the number of the damaged LED reflecting supports prepared during threshing is greater than 600, and the tensile breaking force is only 157 N. A polyester elastomer of polyester-polyester type is used in Comparative Example 2; the number of the damaged LED reflecting supports prepared during threshing is greater than 580, and the tensile breaking force is only 167 N. In Comparative Example 3, a polyester elastomer having a hardness of 84 and a melting point of 221°C was used; the number of the damaged LED reflecting supports prepared during threshing is 393, and the tensile breaking force is 304 N, and the improvement effect is poor. In Comparative Example 4, a polyester elastomer having a hardness of 40 and a melting point of 150°C was used; the number of the damaged LED reflecting supports prepared during degranulation is 423, and the tensile breaking force is 281 N, and the improvement effect is poor.

Those skilled in the art will realize that the examples herein are to help readers understand the principle of the present invention. It should be understood that the protection scope of the present invention is not limited to these particular statement and examples. Those skilled in the art can make various detailed deformations and combinations without departing from the essence of the present invention according to these technical motivations disclosed in the present invention. Moreover, these deformations and combinations still fall within the protection scope of the present invention.

## Claims

1. A polyester resin composition, **characterized in that**, the composition comprises the following components in parts by weight:
40-80 parts of PCT resin;
10-40 parts of a white pigment;
0-30 parts of a reinforcing material;
0.5-5 parts of a polyester elastomer; and
0-10 parts of other additives;
wherein the polyester elastomer comprises a polyester hard segment and a polyether soft segment, and has a Shore hardness of 40-74 and a melting point of 191-221° C.

2. The polyester resin composition according to claim 1, comprising the following parts by weight of components:
50-70 parts of the PCT resin;
20-35 parts of the white pigment;
5-20 parts of the reinforcing material;
1-4 parts of the polyester elastomer; and
2-8 parts of the other additives.

3. The polyester resin composition according to claim 1, wherein the polyester elastomer is of a polyester-ether type, and has a Shore hardness of 46-63, and a melting point of 195-212°C.

4. The polyester resin composition according to claim 1, wherein the PCT resin has an intrinsic viscosity of 0.65-0.75 dL/g.

5. The polyester resin composition according to claim 1, wherein the white pigment is one or more of titanium oxide, zinc oxide, zinc sulfide, white lead, zinc sulfate, barium sulfate, calcium carbonate, and aluminium oxide.

6. The polyester resin composition according to claim 1, wherein the reinforcing material is one or more of glass fiber, wollastonite, potassium titanate whisker, kaolin, talc, and mica.

7. The polyester resin composition according to claim 1, wherein the other additives are one or more of an antioxidant, an impact modifier, a fire retardant, a fluorescent brightener, a lubricating agent, a plasticizer, a thickening agent, an antistatic agent, a nucleating agent, a UV stabilizer, a release agent, a pigment, and a dye.

8. A preparation method of the polyester resin composition according to any one of claims 1-7, **characterized in that**, the method comprises the following steps: mixing the PCT resin, the white pigment, the reinforcing material, the polyester elastomer, and the other additives, conducting melt extrusion and granulation to obtain the polyester resin composition.

9. Use of the polyester resin composition according to any one of claims 1-7 in preparing an LED product.

10. The use of the polyester resin composition in preparing an LED product according to claim 9, wherein the LED product is an LED reflecting support.
